## Europäisches Patentamt
## European Patent Office
## Office européen des brevets

(19)

(11) Veröffentlichungsnummer: **0 016 952**
**B1**

(12) **EUROPÄISCHE PATENTSCHRIFT**

(45) Veröffentlichungstag der Patentschrift:
**19.01.83**

(51) Int. Cl.³: **H 05 K 3/38**, H 05 K 3/28

(21) Anmeldenummer: **80100860.8**

(22) Anmeldetag: **21.02.80**

(54) **Verfahren zum Herstellen von mit Abdeckungen versehenen Leiterplatten.**

(30) Priorität: **06.04.79 US 27629**

(43) Veröffentlichungstag der Anmeldung:
**15.10.80 Patentblatt 80/21**

(45) Bekanntmachung des Hinweises auf die Patenterteilung:
**19.01.83 Patentblatt 83/3**

(84) Benannte Vertragsstaaten:
**DE FR GB**

(56) Entgegenhaltungen:
**DE-A-1 496 748**
**DE-A-2 816 328**
**DE-B-1 264 561**
**GB-A-1 293 801**

(73) Patentinhaber: **International Business Machines Corporation, Armonk, N.Y. 10504 (US)**

(72) Erfinder: **Ellis, Theron LaRue, 1176 Glenwood Road, Vestal New York 13850 (US)**
Erfinder: **Lo, John Choung-Lin, 971 Southern Pines Dr., Endwell New York 13760 (US)**
Erfinder: **Schmitt, George Pershing, 928 Cherry Lane, Vestal New York 13850 (US)**

(74) Vertreter: **Busch, Robert, Dipl.-Ing., Schönaicher Strasse 220, D-7030 Böblingen (DE)**

## Verfahren zum Herstellen von mit Abdeckungen versehenen Leiterplatten

Die Erfindung betrifft ein Verfahren wie es dem Oberbegriff des Patentanspruchs 1 zu entnehmen ist und z. B. aus der US-A-4 127 438 bekannt geworden ist.

Mehrlagen-Leiterplatten finden in zunehmendem Maße Anwendung. Wenn auch durch Verfeinerung und Vervollkommnung der Herstellungsverfahren bisher große Leiterbilddichten herbeizuführen sind, so sind die Erfordernisse der Praxis jedoch darauf gerichtet, Leiterplatten mit noch viel größeren Leiterbilddichten zur Verfügung zu haben, womit dann auch erhöhte Anforderungen bezüglich mechanischer und thermischer Belastung derart dicht gepackter Schaltungsanordnungen einhergehen. Eine entsprechende Widerstandsfähigkeit derartiger Leiterbilder stark heraufzusetzen, muß daher das Bestreben bei dieser Sachlage sein.

Insbesondere treten in Herstellung von Mehrlagen-Leiterplatten Probleme bei selektivem Ätzen der Kupferkaschierung auf dem Basismaterial der jeweiligen Lage und bei Haftverbindung zwischen so freigelegter Oberfläche des Basismaterials und einer über die fertiggestellte Leiterplatte aufgetragener Prepreg-Schicht auf, die nach Aushärtung als Schutzschicht dienen soll.

Bei bekannten Herstellungsverfahren wird die Oberfläche des additiv aufmetallisierten Kupferleiterbildes durch eine Ätzmaske abgedeckt, die für die anschließend speziell angewendete Ätzlösung undurchdringlich ist. Hierzu wird gemäß der genannten US-A-4 127 438 mittels Tauchverfahren eine Zinnschicht auf das Leiterbild aufgebracht, um es so bei nachfolgenden Verfahrensschritten vor Beschädigung zu schützen. Während diese Zinnschutzschicht in der vorgesehenen Funktion als Ätzmaske ihren Dienst leistet, stellt jedoch Auf- und Abtragen auf bzw. von den betreffenden Kupferoberflächen, die hierdurch geschützt werden sollen, erhebliche Schwierigkeiten bei Durchführung dar, so daß das Gesamtherstellungsverfal durch zwangsläufiges Hinzukommen kritischer Verfahrensschritte nur noch mehr belastet wird.

Wie andererseits in der US-Patentschrift 3 791 858 gezeigt, können Leiterplatten auch in eine Ätzlösung getaucht werden, um unerwünschte Kupferbereiche nach aufgebrachten Leiterbildern zu entfernen. Jedoch wird bei solchen Verfahren vorausgesetzt, daß eine oberflächlich aufgetragene Kupferkaschierung mit einer Stärke von nur einigen µm abzutragen ist. Infolgedessen ist ein derartiges Verfahren nicht geeignet für Anwendung auf Leiterplatten, wo leitende Schichten zunächst mit einer Stärke von einigen 10 µm vorgesehen werden. Auch in der US-Patentschrift 3 756 891 ist ein Schnellätzverfahren beschrieben, um unerwünschte Kupferbereiche abzutragen. Beachtet werden muß allerdings, daß durch derartiges Schnellätzen das Leiterbild infolge Abrundens der Leiter- und Anschlußflächenkanten und/oder Unterätzens Schaden nehmen kann.

Sind überschüssige Kupferbereiche vom Basismaterial abgetragen und die diesbezüglichen Verfahrensschritte abgeschlossen, dann stellt sich das obengenannte zweite Problem, nämlich das der Haftverbindung, zu einer über die Leiterplatte aufzutragenden Schutzschicht, die aus teilausgehärtetem, dielektrischen Material besteht. Das Bestreben nach immer dünneren Leitern, um die gewünschte Leiterbilddichte zu erzielen, läßt dieses Problem der Haftverbindung zu einer Schutzschicht immer kritischer werden. Im bereits erwähnten US-Patent 4 127 438 dient zu diesem Zweck eine Chlorit-Oxidschicht, die auf die freigelegten Oberflächenbereiche des Leiterbildes aufgebracht wird, um so eine Haftvermittlung zu begünstigen und mögliche Haftverbindungsprobleme auszuschalten. Unglücklicherweise jedoch neigt ein solcher Chlorit-Haftvermittler zu thermischer Zersetzung, so daß sich, wie die Praxis zeigt, eine zunehmende Anzahl von Haftverbindungsfehlern einstellt, sobald erhöhte thermische Beanspruchungen vorliegen. Zudem noch ist diese Chloritschicht empfindlich gegen Angriffe durch Ätzlösungen, Treibungsmittel und Lochreinigungsmaterialien, wie sie in Vorbereitung zur Lochmetallisierung fertiggestellter Leiterplatten Anwendung finden, so daß hierdurch auch die Ausschußrate nicht unwesentlich erhöht wird.

Aus der Veröffentlichung »National Bureau of Standards Circular«, Publication Nr. 192 vom 22. November 1948, ist es bekannt, eine Haftverbindung zwischen Metall und Nichtmetall durch Aufrauhen der betreffenden zu verbindenden Oberfläche oder durch Vorsehen mechanischer Verzahnung mittels entsprechender Oberflächen-Auszackung zu begünstigen. Ähnliches ergibt sich auch aus vorgenanntem US-Patent 3 791 858, wo ein Einschluß von Mikropartikel in die zu verbindende Oberfläche hierzu vorgeschlagen wird. Auch hier wiederum, ähnlich wie im Fall der Anwendung des Chlorit-Haftvermittlers, führen derartige Maßnahmen jedoch zu Aufwandserhöhung und damit zur Erschwerung der Herstellung von Mehrlagen-Leiterplatten und/oder machen die Anwendung von Verfahren erforderlich, die die Güte fertiggestellter Leiterplatten herabzusetzen vermögen.

Die Verwendung reaktionsträger Metalle ist bereits zur Metallisierung dielektrischen Basismaterials vorgeschlagen worden. Ein derartiger Vorschlag findet sich z. B. im »IBM Technical Disclosure Bulletin«, Band 4, Nr. 7, Dezember 1961, auf den Seiten 17 und 18. In diesem Artikel wird die Verwendung von Palladium als katalytisches Agens für den zunächst aufgebrachten Überzug des dielektrischen Basismaterials vorgeschlagen. Auch im bereits erwähnten US-Patent 3 756 891 wird stromloser Niederschlag von Metall, nämlich Kupfer, angeführt, indem dielek-

trisches Basismaterial mit katalytischem Metall, nämlich Palladium, vorbehandelt wird, um das Substrat für darauffolgende chemische Reduktion des erwünschten Metallions zur Begünstigung der Metallisierung zu präparieren.

Verfahren zur Bildung von Mehrlagen-Leiterplatten und speziell der diesbezüglichen Schichten sind an sich bekannt. Hierzu sei nur auf die US-Patentschriften 3 791 858, 3 969 177 und 4 030 190 verwiesen.

Es sei betont, daß Herstellung derartiger Mehrlagen-Leiterplatten bekanntlich eine relativ hohe Anzahl von Prozeßschritten bedingt, von denen einige kompliziert, aufwendig und zudem noch hinsichtlich Zuverlässigkeit so erstellter Leiterplatten zu mittelmäßigen Ergebnissen führen. Dies bezieht sich insbesondere auf Folgen von Verfahrensschritten, die zum Schutz der Leiterbilder während nachfolgender Ätzvorgänge und zur Haftverbindung mit einer Prepreg-Schicht in einem darauffolgenden Laminationsverfahrensschritt Anwendung finden.

Demgemäß besteht die Aufgabe der Erfindung darin, ein Verfahren, wie z. B. in US-A-4 127 438 gezeigt, so zu verbessern, daß sich in zuverlässiger Weise Leiterbilder höchster Dichte auf Leiterplatten aufbringen lassen, wobei die Haftverbindung mit einer abschließend aufgebrachten Schutzschicht unter allen Umständen gewährleistet ist, indem vor allem gegenüber bisher die Anzahl der Vefahrensschritte herabgesetzt wird.

Erfindungsgemäß wird diese Aufgabe gelöst, wie es dem Kennzeichen des Patentanspruchs 1 zu entnehmen ist.

Es hat sich gezeigt, daß bei derart hergestellten Leiterplatten die Widerstandsfähigkeit gegenüber thermischen Beanspruchungen im Vergleich zu mit bisher bekannten Verfahren hergestellten Leiterplatten wesentlich erhöht wird; wobei sich zudem noch zeigt, daß dank der Erfindung auch Alterungseinflüsse weniger nachteilig als bisher in Erscheinung treten. Infolge der Herabsetzung der Anzahl von Verfahrensschritten und der erzielten höheren Zuverlässigkeit der so erstellten Leiterplatten ist also das erfindungsgemäße Verfahren gegenüber bekannten Verfahren wirtschaftlicher und bietet somit entsprechende Vorteile.

Aus der DE-A-2 816 328 ist es bekannt, zum Herstellen elektrischer Kontaktflächen Palladium unter derartigen Bedingungen auf Kupfer niederzuschlagen, daß sich in den freien Oberflächen dendritische oder warzenförmigen Auswüchse auszubilden vermögen. Auf diese Weise lassen sich Kontakte zum Herbeiführen betriebssicherer, lösbarer Verbindungen erhalten.

Dank der erfindungsgemäß herbeigeführten dendritischen und/oder warzenförmigen Auswüchse auf Leiterbildoberflächen ergibt sich demgegenüber eine zuverlässig und dauerhaft wirkende Haftvermittlungsschicht, die zusätzlich noch als Ätzmaske dient, zu nachträglich auf den betreffenden Leiterplatten aufgebrachten, während des Auftragungsvorgangs teilausgehärteten Schutzschichten.

Die Erfindung wird anschließend anhand einer Ausführungsbeispielsbeschreibung mit Hilfe der unten aufgeführten Zeichnungen näher erläutert. Es zeigt

Fig. 1 Querschnittsausschnitte eines Nutzens jeweils nach Abschluß der einzelnen Verfahrensschritte zur Herstellung einer Leiterplatte gemäß dem Stand der Technik,

Fig. 2 Nutzen-Querschnittsausschnitte jeweils nach Abschluß der erfindungsgemäß vom Stand der Technik abweichenden Herstellungsverfahrensschritte.

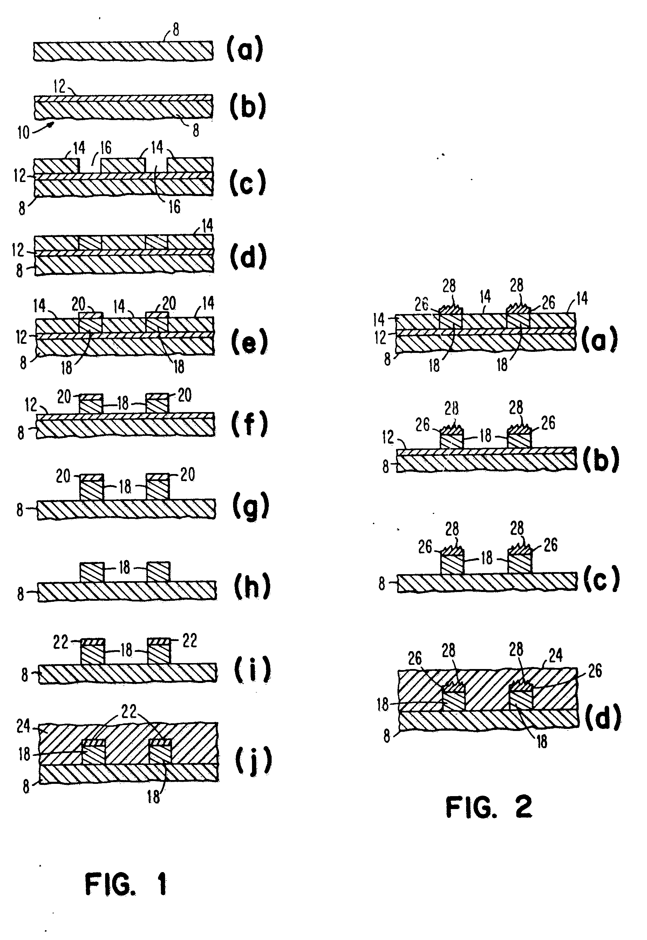

Der sich auf Fig. 1 beziehende Verfahrensablauf zur Herstellung von Leiterplatten hat weitgehend Anwendung gefunden und sei somit als typisch für Herstellungsverfahren gemäß dem Stand der Technik herausgestellt.

Nutzen, wie sie hier zu verstehen sind, bestehen im weitesten Sinne aus einer Anzahl dielektrischer Schichten oder einem Laminat als Basis. Im vorliegenden Falle wird davon ausgegangen, daß ein Nutzen 8 (Fig. 1A) dadurch gebildet wird, daß ein Glasgewebeband durch eine Epoxid-Kunstharzlösung gezogen wird, so daß das Gewebe hierdurch imprägniert wird. Anschließend werden dann Lösungsüberschüsse abgetropft und das kunstharzimprägnierte unter Anwendung von wärmeaushärtbare Glasgewebeband nur zu einem gewissen Grade ausgehärtet, d. h. der Epoxid-Kunstharzanteil im Glasgewebe wird bis zu einem vorgebbaren Zustand der Teilaushärtung polymerisiert. Der solchermaßen teilausgehärtete Trägerwerkstoff, als Prepreg im B-Zustand, wird dann zur Weiterverarbeitung in Nutzen vorgegebener Größe zerschnitten. Zusätzliche und spezielle Einzelheiten betreffend die Trägerwerkstoff-Verarbeitung und die Zusammensetzung eines hierfür typischen Epoxid-Kunstharzes lassen sich dem US-Patent 3 523 037 entnehmen. Im Anschluß an den Schneidvorgang lassen sich die noch immer teilausgehärteten Nutzen leicht behandeln, ohne Gefahr zu laufen, daß sie in unerwünschter Weise aneinander oder an anderen Gegenständen kleben bleiben.

Das in Fig. 1b gezeigte kupferkaschierte Basismaterial 10 läßt sich aus einer Anzahl von Nutzen 8 bilden, wobei deren Anzahl von der gewünschten Dicke der dielektrischen Schicht des bereitzustellenden kupferkaschierten Basismaterials 10 abhängig ist. Der besseren Übersichtlichkeit halber ist in Fig. 1b lediglich ein Bruchteil eines Nutzens 8 im Verband des kupferkaschierten Basismaterials 10 gezeigt. Eine etwa 5 µm dicke Kupferkaschierung 12, die auch durch eine leitende Schicht anderen geeigneten Materials ersetzt sein kann, ist auf zumindest eine der freien Oberflächen des Basismaterials nach deren völliger Aushärtung aufgebracht. Vorzugsweise wird diese Kupferkaschierung, ausgehend von einer entsprechenden Kupferfolie, auf das dielektrische Basismaterial 10 aufgetragen. Ebensogut läßt sich aber auch diese Kupferkaschierung 12 auf das Basismaterial mit Hilfe an sich ebenfalls bekannter Metallisierungsverfahren additiv aufbringen. Auf jeden Fall soll gewährleistet sein, daß diese Kupferkaschierung 12 fest auf der Oberfläche des Basismaterials 10 haftet, das seinerseits unter Anwenden entsprechender Aufheizung und geeigneten Drucks mit Hilfe einer Presse völlig ausgehärtet worden ist.

Auf das so gebildete kupferkaschierte Basismaterial 10 wird oberhalb der Kupferkaschierung 12 eine Fotolackschicht 14 aufgebracht, die ihrerseits über eine Maske zum Festlegen des auf das kupferkaschierte Basismaterial 10 aufzubringenden Leiterbildes belichtet wird. Nach Beendigung eines daran anschließenden Entwicklungsvorgangs werden die exponierten Bereiche der Fotolackschicht 14 mit Hilfe einer geeigneten Lösung abgetragen, so daß sich ein Leiterbildmuster, wie andeutungsweise in Fig. 1c gezeigt, ergibt. Der Einfachheit halber sei hier angenommen, daß das aufzubringende Leiterbild lediglich aus zwei Leitern, die in den Zwischenräumen 16 der Fotolackschicht 14 auf dem kupferkaschierten Basismaterial 10 zu liegen kommen sollen, bestehen.

In Fortführung des Herstellungsverfahrens wird dann unter Anwenden eines Metallisierungsverfahrens das Leiterbild auf das kupferkaschierte Basismaterial 10 aufgebracht (Fig. 1d). Hat das Leiterbild eine als geeignet erachtete Höhe erreicht, die im allgemeinen der Dicke der Fotolackschicht 14 entspricht, dann werden die Leiter 18 des Leiterbildes unter Anwenden eines Tauchverfahrens mit einer Zinnschicht 20 überzogen, so daß sich der in Fig. 1e gezeigte Querschnittsausschnitt ergibt. Die Zinnschicht 20 soll zum Schutz des Leiterbildes während nachfolgend angewendeter Verfahrensschritte zum Abtragen der verbliebenen Fotolackschichtreste (Fig. 1f) und zum Abätzen nun freiliegender Bereiche der Kupferkaschierung 12 (Fig. 1g) dienen. Hierauf wird die Zinnschicht 20 selbst abgetragen (Fig. 1h), um durch eine Chloritschicht 22 ersetzt zu werden (Fig. 1i), die ihrerseits als Haftvermittler einer anschließend aufzutragenden Schicht als Abdeckung 24, wie in Fig. 1j gezeigt, vorgesehen ist. In typischer Weise besitzt diese Chloritschicht eine Dicke zwischen 40 bis 180 nm und besteht aus einer Mischung mit Kupfer und Kupferoxid (CuO und CuO$_2$). Die Abdeckung 24 setzt sich ebenfalls aus einem oder mehreren Prepregs zusammen, die mit dem Basismaterial 10 unter geeigneter Wärme- und Druckbehandlung verpreßt wird. Bei Anwenden eines Prepregs kann ein Klebmittel oder ein Bindemittel zur gegenseitigen Befestigung von Basismaterial 10 und Abdeckung 24 während des hierzu angewendeten Laminierungsvorgangs dienen.

Für den mit Fig. 1 nur grob angedeuteten Verfahrensablauf sind jedoch 45 Einzelverfahrensschritte erforderlich, um die in Fig. 1j gezeigte Leiterplatte zu erhalten. Ein derartiger Herstellungsvorgang schließt Probleme sowohl bei Herstellung als auch bei anschließender Verwendung derart hergestellter Leiterplatten ein.

Wie bereits erwähnt, ist die Verwendung der Chloritschicht bei den bekannten Herstellungsverfahren insofern als erforderlich erachtet, als damit eine geeignete Haftvermittlung zur nachfolgend aufzutragenden Abdeckung bereitgestellt werden soll. Es hat sich herausgestellt, daß diese Chloritschicht aber bezüglich ihrer Haftvermittlungseigenschaft dann beeinträchtigt werden kann, wenn aus welchen Gründen auch immer, die Behandlungs- oder Betriebstemperatur des Werkstücks bzw. der Leiterplatte erhöht werden muß. So besitzt z. B. eine in einem Herstellungsprozeß gemäß Fig. 1 hergestellte Leiterplatte eine absehbare Lebensdauer von etwa 500 000 Stunden, wenn von der durch die Chloritschicht begünstigten Haftvermittlung unter Normalbedingungen ausgegangen wird. Wird die Temperatur aber auf 80°C erhöht, dann reduziert sich die betreffende Lebensdauer der Leiterplatte auf nur etwa 100 000 Stunden.

Ein weiteres Problem ergibt sich aufgrund des Unterätzens an metallisierten Löchern in den Leiterplatten, wo die jeweilige Chloritschicht im Bereich der hier vorliegenden Lötaugen durch Prozeßchemikalien angegriffen wird, als da sind Ätzmittel, Lochreinigungsmittel und dgl., wie sie vor Metallisieren der Löcherwandungen Anwendung finden. Zusätzlich zur erwähnten thermisch bedingten Zersetzung des Chlorit-Haftvermittlers und der Anfälligkeit gegenüber Angriffen seitens der Prozeßchemikalien ergibt sich ein weiterer negativer Aspekt, der sich aus der Verwendung von im Tauchverfahren aufgebrachten Zinn als Ätzmaske ergibt. In gewisser Weise sind nämlich Anwendung von im Tauchverfahren aufgebrachtem Zinn und anschließend vorzunehmende Abtragungsverfahrensschritte kritisch, so daß erhebliche Leiterplattenfehler bei Prüfen der Haftfähigkeit zu verzeichnen sind. Alle genannten Probleme lassen sich jedoch zufriedenstellend durch Anwenden des erfindungsgemäßen Verfahrens bei Fertigung von Mehrlagen-Leiterplatten lösen. Das erfindungsgemäße Herstellungsverfahren vermeidet nicht nur die obengenannten Schwierigkeiten, sondern stützt sich außerdem noch auf eine erheblich verringerte Anzahl von Verfahrensschritten zur Herstellung derartiger Leiterplatten. Erfindungsgemäß ergeben sich diese Vorteile durch Aufbringen einer mit Dendriten versehenen Palladiummaske, die auf die Oberfläche des Leiterbildes, wie im einzelnen unten aufgeführt, aufgebracht wird.

Wie Fig. 2a zu entnehmen ist, wird im Anschluß an die Metallisierung des Leiterbildes, bestehend aus den Leitern 18, bei noch vorhandener exponierter Fotolackschicht 14 eine Palladiumschicht 26 auf das Leiterbild aufgetragen. Die erfindungsgemäße Abänderung des Prozesses schaltet also das Anwenden eines Tauchverfahrens aus, so daß die hiermit verbundenen, oft kritischen Verfahrensschritte zu Metallisierung und Abtragung nicht zur Auswirkung gelangen können. Es sei jedoch an dieser Stelle betont, daß, wenn erfindungsgemäß vorzugsweise Palladiumdendrite Anwendung finden, ebensogut auch andere reaktionsträge Metalle für den vorgesehenen Zweck geeignet sein können.

Die Palladiumschicht 26 wird additiv auf die Oberfläche des Leiterbildes in einem Galvanisierungsbad aufgetragen, in dem die Stromdichte höher und die Metallkonzentration geringer ist, als es normalerweise d. h. zur Erzielung glatter, glänzender Metallisierungs-Oberflächen der Fall ist. Zusätzlich wird noch das Galvanisierungsbad während des Metallisierungsvorganges mehr als üblich durchgeführt. Weitere und speziellere Einzelheiten der Metallisierungsbedingungen um Oberflächendendrite zu erhalten, lassen sich der DE-OS-2 816 328 entnehmen. Der Palladium-Metallisierungsverfahrensschritt entsprechend den vorgenannten Kriterien läßt eine Palladiumschicht 26 entstehen, deren Oberfläche mit Dendriten überdeckt ist oder warzige Auswüchse aufweist, welche sich von der Oberfläche nach oben erstrecken. Die so erhaltene Palladiumschicht 26 besitzt in typischer Weise eine Dicke von etwa 2,5 µm.

Nach Auftragen dieser Palladiumschicht 26 wird die Fotolackschicht 14 abgetragen, so daß sich die Darstellung nach Fig. 2b ergibt. Anschließend werden die überschüssigen Bereiche der Kupferkaschierung 12 mittels eines Ätzvorgangs entfernt, wobei sich dann eine Anordnung nach Fig. 2c ergibt. Die Palladiumschicht 26 dient hierbei als Ätzmaske, um das Leiterbild beim Abtragen der Fotolackschicht 14 und insbesondee beim Abätzen der überschüssigen Bereiche der Kupferkaschierung 12 zu schützen. Im Gegensatz zu bekannten Herstellungsverfahren, bei denen durch Tauchverfahren aufgebrachtes Zinn als Schutzätzmaske Anwendung findet, wird bei Anwenden des erfindungsgemäßen Verfahrens die Palladiumschicht 26 unter Ersparen des Auftragens einer besonderen Haftvermittlungsschicht nicht abgetragen, so daß hierdurch der Aufwand, insbesondere bezüglich Prozeßzeit, herabgesetzt wird sowie Schwierigkeiten vermieden werden.

Bei Ausüben der erfindungsgemäßen Verfahrens ist die Anwendung einer Chloritschicht nicht nötig, da wie bereits gesagt, die Palladiumschicht 26 dank der auf ihrer Oberfläche vorhandenen Dendrite in vorteilhafter Weise zusätzlich zur Haftvermittlung dient. Wie aus Fig. 2d hervorgeht, wird die anschließend aufgebrachte, nur teilweise ausgehärtete und mit der Leiterplatte zu 8 verklebende Abdeckung 24 außerdem noch über die dendritischen bzw. warzigen Auswüchse 28 mechanisch hiermit verbunden, so daß eine ausgezeichnete Haftvermittlung gewährleistet ist. Fernerhin zeigt sich, daß Palladium eine geringere Oberflächenbenetzungsspannung als Chlorit besitzt, so daß die mit Palladium bedeckte Oberfläche des Kupfer-Leiterbildes ein besonders stark ausgeprägtes Haftvermögen aufweist. Hinzu kommt, daß sich im Gegensatz zu einem Chlorit-Haftvermittler Palladium nicht mit der Zeit zersetzt und demgegenüber erheblich stabiler bei erhöhten Temperaturen bleibt. Zusätzlich zu diesen Vorteilen ergeben sich noch weitere, wenn die den metallisierten Löchern zugeordneten Lötaugen betrachtet werden, wo Palladium ohne weiteres den zur Reinigung der Löcher vor Metallisieren angewendeten Prozeßchemikalien widersteht, im Gegensatz zu bisher aufgebrachten Chloritschichten, die hierbei mehr oder weniger verletzt werden, so daß sich demgemäß ein entsprechender Leiterplattenausschuß ergibt.

## Patentansprüche

1. Verfahren zum Herstellen von mit Abdeckungen (24) versehenen Leiterplatten unter Verwendung von kupferkaschiertem Basismaterial (10; 8, 12), wobei die Oberfläche von Leiterbildern (18) vor Abtragen der zum Aufbringen des Leiterbildmetalls auf die Kupferkaschierung (12) aufgetragenen Fotolackschicht (14) mit einer Ätzmaske (26) überzogen wird, dadurch gekennzeichnet, daß als Ätzmaske Palladium elektrolytisch unter derartigen Bedingungen auf die Leiterbilder niedergeschlagen wird, daß sich an den freien Oberflächen der Ätzmaske (26) dendritische oder warzenförmige Auswüchse (28) auszubilden vermögen, die zur Haftvermittlung mit den nach Abtragen der freigelegten Kupferkaschierung (12) auf die Leiterbilder (18) und das sie tragende Basismaterial (8) aufgebrachten Abdeckungen (24) beitragen.

2. Verfahren nach Anspruch 1, dadurch gekennzeichnet, daß bei voll ausgehärtetem Basismaterial (10) die Abdeckung (24) in Form einer Lage aus teilausgehärtetem dielektrischen Material auf die jeweilige Leiterplatte aufgebracht wird.

## Claims

1. Method of producing circuit boards provided with coatings (24), using copper laminated base material (10; 8, 12) wherein the surface of conductive patterns (18) prior to removing the photoresist layer (14), applied to the copper layer (12), is covered with an etch mask (26), characterized in that palladium is electrolytically deposited as an etch mask on the conductive patterns in such a manner that dendritic or nodular projections are formed in the free surface regions of the etch mask (26), these projections promoting the adhesion of the coatings (24) applied after removal of the exposed copper layer (12) to the conductive patterns (18) and the base material (8) carrying said conductive patterns.

2. Method according to claim 1, characterized in that after the base material (10) has been fully cured, the coating (24) is applied as a layer of partially cured dielectric material to the respective circuit board.

## Revendications

1. Procédé pour fabriquer des cartes imprimées pourvues de réserves (24) en utilisant un support isolant à revêtement de cuivre (10; 8, 12), la surface d'impression conductrice (18) étant revêtue d'un masque de décapage (26) avant l'enlèvement de la couche de résine photosensible (14) déposée sur le revêtement en cuivre (12) pour réaliser la métallisation de l'impression conductrice, ledit procédé étant caractérisé en ce qu'on dépose sur l'impression conductrice, par électrolyse, du palladium comme masque de décapage dans des conditions telles que sur les surfaces libres du masque de décapage (26) peuvent se former des excroissances dendritiques ou nodulaires (28) qui améliorent l'adhésion des réserves (24) déposés, après l'enlèvement du revêtement en cuivre exposé (12), sur l'impression conductrice (18) et le support isolant sous-jacent (8).

2. Procédé selon la revendication 1, caractérisé en ce qu'on dépose, sur la carte imprimée respective, la réserve (24), sous forme d'une couche de matériau diélectrique partiellement durci, le support isolant (10) ayant été soumis à un durcissement complet.

FIG. 1

FIG. 2